# EUROPEAN PATENT APPLICATION

(11) **EP 4 535 023 A1**
(43) Date of publication of application: **09.04.2025**
(21) Application number: 24204931.0
(22) Date of filing: 07.10.2024
(51) Int. Cl.: G01R 33/56, G01R 33/565, G06T 5/60, G06N 3/045

(54) **MAGNETIC RESONANCE IMAGING APPARATUS AND IMAGE PROCESSING METHOD**

(30) Priority: 06.10.2023 JP 2023174398
(71) Applicant: FUJIFILM Corporation, Tokyo 106-8620 (JP)
(72) Inventor: SHIRAI, TORU, Tokyo, 106-8620 (JP); AMEMIYA, TOMOKI, Tokyo, 106-8620 (JP); YOKOSAWA, SUGURU, Tokyo, 106-8620 (JP); SUZUKI, ATSURO, Tokyo, 106-8620 (JP); KANEKO, YUKIO, Tokyo, 106-8620 (JP); NISHIO, KEISUKE, Tokyo, 106-8620 (JP); MURASE, TAKENORI, Tokyo, 106-8620 (JP)
(74) Representative: Dehns Germany Partnerschaft mbB

(57) **Abstract**

Provided is a technology of obtaining a high Gibbs ringing correction effect for various input data.

A ringing correction unit (233) that performs Gibbs ringing correction on an image reconstructed at a reconstruction matrix size having a predetermined matrix ratio to a matrix size of measurement data is prepared, and in image reconstruction, first, reconstruction is performed at the reconstruction matrix size in which the matrix size of the measurement data and the reconstruction matrix size have the predetermined matrix ratio, to obtain an intermediate reconstructed image. The ringing correction is performed on the intermediate reconstructed image by the ringing correction unit (233), and then the intermediate reconstructed image is transformed into k-space data and reconstructed at a final image reconstruction matrix size.

## Description

### CROSS-REFERENCE TO RELATED APPLICATIONS

The present application claims priority under 35 U.S.C. § 119 to Japanese Patent Application No. 2023-174398, filed October 6, 2023. Each of the above application(s) is hereby expressly incorporated by reference, in its entirety, into the present application.

### BACKGROUND OF THE INVENTION

### 1. Field of the Invention

The present invention relates to a magnetic resonance imaging apparatus, and more particularly, to a ringing correction technology of an image acquired by the magnetic resonance imaging apparatus.

### 2. Description of the Related Art

A magnetic resonance imaging (MRI) apparatus applies phase encoding to a nuclear magnetic resonance signal (echo signal) generated by a subject using a gradient magnetic field and collects the echo signals with different frequencies within a sampling time by using the gradient magnetic field in a direction orthogonal to a phase encoding direction in a case in which the nuclear magnetic resonance signal is sampled. Data consisting of a large number of echo signals having different types of phase encoding is measurement data having a matrix size determined by the number of types of phase encoding and the number of samplings, that is, k-space data. The MRI apparatus reconstructs an image of the subject by performing processing such as a Fourier transform on the k-space data.

The matrix size during measurement (measurement matrix size) varies depending on imaging conditions such as restrictions of the apparatus and an imaging time. On the other hand, the matrix size of the image to be reconstructed (reconstruction matrix size) may be the same as the measurement matrix size, but in order to obtain an image with a desired resolution, the image is often reconstructed with a matrix size different from the measurement matrix size. In this way, in the MRI, the measurement matrix size and the reconstruction matrix size also vary.

Since the measurement matrix size is discrete and finite in a frequency space, in a case in which the measurement matrix size and the reconstruction matrix size are different from each other and a ratio thereof deviates from 1:1, a periodic or streak artifact called a Gibbs ringing or a truncation artifact (hereinafter referred to as ringing) is more strongly generated in the reconstructed image. This ringing can be suppressed, for example, by applying a k-space filter that smooths a high-frequency region to the measurement data, but there is a disadvantage that the sharpness of the image is decreased and the image is blurred by the application of the k-space filter.

Meanwhile, a technology of correcting the ringing without decreasing the sharpness has also been proposed. For example, Qianqian Zhang et al. Magn Reson Med. 2019;82:2133-2145 proposes using a deep learning model, such as a CNN, which has been trained by using images reconstructed by combining various measurement matrix sizes and reconstruction matrix sizes. In addition, the present applicants also propose a technology of performing ringing artifact removal processing on an image reconstructed by expanding a measurement matrix through zero-filling, before noise processing (JP2021-171490A).

### SUMMARY OF THE INVENTION

The technology described in JP2021-171490A is based on the premise that the noise processing in a sparse space is performed on the image, and expands the measurement data by zero-filling such that the measurement data exceeds the reconstruction matrix size. However, since the ringing is not sparse even in the sparse space, the effectiveness as the ringing correction technology is low. In addition, in the technology disclosed in Qianqian Zhang et al. Magn Reson Med. 2019;82:2133-2145, an expected ringing correction effect cannot be obtained depending on the data to be input to the trained CNN. In this technology, in order to handle combinations of various matrix sizes, an enormous number of images are required as training data for the CNN, which is not realistic.

An object of the present invention is to provide a technology of obtaining a high Gibbs ringing correction effect for various input data. In particular, an object of the present invention is to provide a technology capable of training a CNN with a relatively small amount of training data and obtaining a high Gibbs ringing correction effect in the ringing correction technology using the CNN.

In order to achieve the above-described object, an MRI apparatus of an aspect of the present invention prepares a ringing correction unit that maximizes a ringing correction effect for an image reconstructed at a reconstruction matrix size having a predetermined matrix ratio to a matrix size of measurement data, and performs two-stage reconstruction in image reconstruction. In the first-stage reconstruction (first reconstruction), the reconstruction is performed such that the matrix size of the measurement data and the reconstruction matrix size achieve the matrix ratio at which the maximum effect is obtained in the ringing correction unit, to obtain an intermediate reconstructed image. Ringing correction is performed on the intermediate reconstructed image, and then the second-stage image reconstruction (second reconstruction), which is the final image reconstruction, is performed. In the second reconstruction, the reconstructed image after the ringing correction is transformed into the measurement data, and the reconstruction is performed such that the measurement data has a desired reconstruction matrix size, that is, a reconstruction matrix size set by a user.

Specifically, an aspect of the present invention provides an MRI apparatus comprising: an imaging unit that collects measurement data consisting of magnetic resonance signals; an image generation unit that reconstructs the measurement data at a desired reconstruction matrix size; and a ringing correction unit that performs ringing correction on a reconstructed image.

The image generation unit includes a matrix size setting unit that sets a measurement matrix size of the measurement data, an intermediate reconstruction matrix size having a predetermined matrix ratio to the measurement matrix size, and the desired reconstruction matrix size, a first reconstruction unit that reconstructs the measurement data at the intermediate reconstruction matrix size to generate an intermediate reconstructed image, and a second reconstruction unit that reconstructs k-space data of a corrected intermediate reconstructed image obtained by performing ringing correction on the intermediate reconstructed image via the ringing correction unit, at the desired reconstruction matrix size. At least one of the image generation unit, the matrix size setting unit, the first reconstruction unit, the second reconstruction unit, or the ringing correction unit can be implemented by one or more processors, i.e. the one or more processors are configured to perform the above-mentioned steps.

In the preferred aspect of the present invention, the ringing correction unit includes a CNN that has been trained by using a plurality of image sets consisting of a first image in which ringing has not occurred and a second image in which ringing has occurred, and the second image is an image obtained by changing a size of the first image and reconstructing the first image in a k-space at the predetermined matrix ratio.

Another aspect of the present invention provides an image processing method of reconstructing a ringing-corrected image by using measurement data consisting of magnetic resonance signals collected by a magnetic resonance imaging apparatus.

The image processing method comprises a first reconstruction step of reconstructing the measurement data at a reconstruction matrix size having a predetermined matrix ratio to a measurement matrix size to generate an intermediate reconstructed image; a correction step of performing ringing correction on the intermediate reconstructed image by using a CNN that has been trained by using a set including a first image in which ringing has not occurred and a second image in which ringing has occurred and that outputs an image in which ringing is corrected with respect to an input image; and a second reconstruction step of transforming the intermediate reconstructed image after the ringing correction into k-space data and reconstructing the k-space data at a desired reconstruction matrix size.

The second image used for training the CNN is an image which is obtained by changing a size of the first image and reconstructing the first image in a k-space at a reconstruction matrix size of the first image and in which the reconstruction matrix size and a matrix size after the size change satisfy the predetermined matrix ratio.

According to aspect of the present invention, the image having the desired matrix size (resolution) in which the Gibbs ringing is reduced can be acquired by performing the reconstruction after fixing the ratio (matrix ratio) between the measurement matrix size and the reconstruction matrix size, performing the ringing correction processing with the matrix ratio, and then performing the reconstruction with the final reconstruction matrix size.

In addition, for example, in a case in which the ringing correction is performed by using the CNN or the like, the trained CNN that can effectively perform the ringing correction can be constructed by using only the training image set in which the matrix ratio is fixed as the training data without significantly increasing the amount of training data.

In the ringing correction technology of the aspect of the present invention, since the only necessary condition in the construction of the ringing correction unit is the fixing of the matrix ratio, the ringing correction technology can be applied to any spatial resolution and matrix size used in an examination, without depending on an imaging part and a contrast, and can be applied to both 2D imaging and 3D imaging regardless of the sampling pattern, thereby ensuring a reliable Gibbs ringing correction effect.

### BRIEF DESCRIPTION OF THE DRAWINGS

Fig. 1 is a diagram showing an overall configuration of an MRI apparatus to which the present invention is applied.
Fig. 2 is a functional block diagram of an image processing unit.
Fig. 3 is a diagram showing an outline of an image processing procedure.
Fig. 4 is a diagram showing a relationship between a measurement matrix size and a reconstruction matrix size.
Fig. 5 is a diagram showing the occurrence of Gibbs ringing.
Fig. 6 is a diagram showing an example of a structure of a CNN adopted in Embodiment 1.
Fig. 7 is a diagram showing a training image set for the CNN.
Fig. 8 is a diagram showing a flow of image processing in Embodiment 1.
Fig. 9 is a diagram showing the processing of Embodiment 1.
Fig. 10 is a diagram showing a part of the processing of Embodiment 1.
Fig. 11 is a diagram showing another part of the processing of Embodiment 1.
Fig. 12 is a diagram showing a configuration example of an image processing unit of Embodiment 2.

### DESCRIPTION OF THE PREFERRED EMBODIMENTS

Hereinafter, embodiments of an MRI apparatus and an image processing method realized by the MRI apparatus according to an embodiment of the present invention will be described with reference to the accompanying drawings.

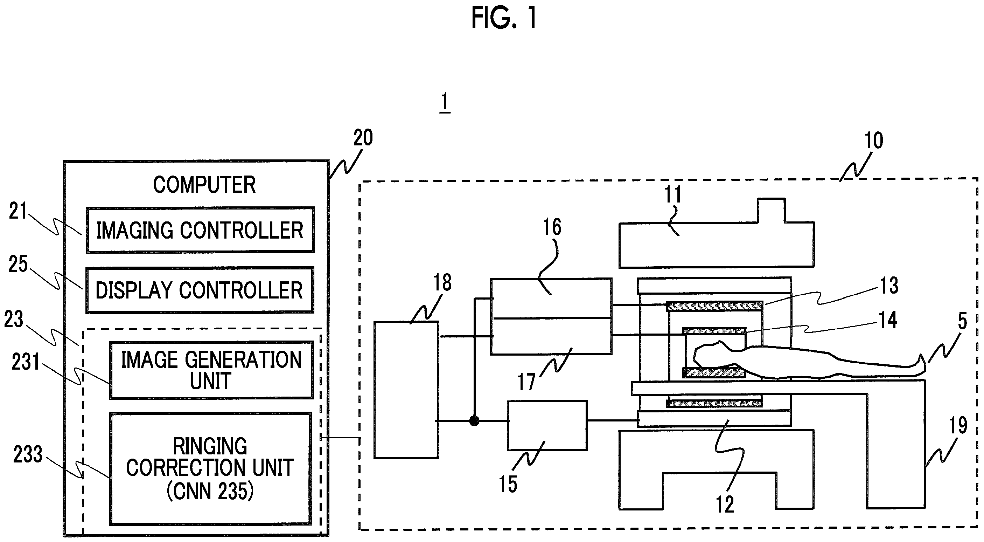

First, an outline of a configuration of an MRI apparatus 1 to which the present invention is applied will be described. The present invention can be applied to most types of MRI apparatuses that are currently in widespread use, and the configuration thereof roughly includes an imaging unit 10 that collects nuclear magnetic resonance signals, a computer 20 that controls the imaging unit and performs various types of operations, and various devices that are associated with the imaging unit 10 and the computer 20, such as an input device, a display device, and an external storage device, as shown in Fig. 1.

Since the configuration of the imaging unit 10 is the same as a configuration of a normal MRI apparatus, a detailed description thereof will be omitted, but the imaging unit 10 comprises a static magnetic field magnet 11 that generates a static magnetic field space in which a subject 5 is placed, a gradient magnetic field coil 12 that applies a gradient magnetic field in a static magnetic field, an RF transmission coil 13, an RF receive coil 14, a gradient magnetic field power supply 15 that drives these coils and a transmitter 16, a receiver 17 to which a high-frequency receive coil is connected, and a bed device 19 that transports the subject 5 into the static magnetic field space. Further, the imaging unit comprises a sequencer 18 that controls the operations of sampling the signals via the gradient magnetic field coil 12, the RF transmission coil 13, and the RF receive coil 14 in accordance with a pulse sequence.

The computer 20 includes an imaging controller 21 that controls the operation of the imaging unit 10 via the sequencer 18, an image processing unit 23 that performs image reconstruction and other processing on measurement data (k-space data) collected by the imaging unit 10, and a display controller 25 that controls the display of the reconstructed images, a GUI, and the like.

The computer 20 can be configured as a general-purpose computer comprising one or more processors, e.g. a CPU or a GPU, and a memory, and the above-described functions of the computer are programmed in advance and realized by uploading the program to the one or more processors. In addition, some functions of the computer may be realized by hardware such as an ASIC or a programmable IC, and the computer according to the embodiment of the present invention includes these hardware components.

In the MRI apparatus 1 according to the present embodiment, the computer 20 comprises a ringing correction unit that performs ringing correction on the image reconstructed at a specific matrix ratio. Such a ringing correction unit is not limited, but is typically a specific CNN that has been trained for Gibbs ringing correction, and the computer 20 is has a form in which such a ringing correction unit (CNN) is available, for example, by having a specific CNN built-in or being connectable to a specific CNN. It should be noted that, as a ringing correction unit instead of the CNN, linear prediction processing for predicting a zero-fill region of a k-space to be extrapolated in accordance with frequency characteristics of the ringing may be adopted.

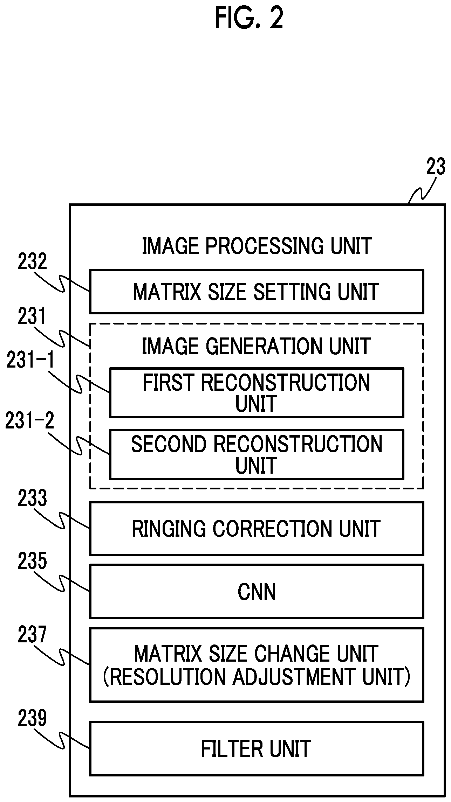

Hereinafter, an embodiment of the image processing unit 23 will be described. Here, as an example, Fig. 2 shows a configuration example of the image processing unit 23 in which a CNN 235 is incorporated into the computer 20. As shown in Fig. 2, the image processing unit 23 comprises an image generation unit 231 that performs operations such as a Fourier transform on the measurement data to generate an image having a desired reconstruction matrix size, and a ringing correction unit 233 that corrects the ringing that has occurred in the image.

The ringing correction unit 233 includes the CNN 235 that has been trained by using training data of a predetermined matrix ratio, and corrects the Gibbs ringing in the image by applying the CNN. The image generation unit 231 comprises a first reconstruction unit 231-1 that transforms the measurement data into image data at the same matrix ratio as the training data of the CNN to generate an intermediate reconstructed image, and a second reconstruction unit 231-2 that transforms the intermediate reconstructed image into measurement space data (that is, k-space data) to reconstruct the measurement space data at a desired matrix size. It should be noted that, for convenience of separately describing the functions of the image generation unit 231, the image generation unit 231 is shown as two reconstruction units 231-1 and 231-2, but this description means that two functions are provided, and also includes a case in which one or more processors execute the functions of the two reconstruction units 231-1 and 231-2 as the hardware.

The image processing unit 23 further comprises a matrix size setting unit 232 that sets a matrix size required for processing via the first reconstruction unit 231-1, that is, an intermediate reconstruction matrix size, and a matrix size required for processing via the second reconstruction unit 231-2, that is, a final reconstruction matrix size, and a matrix size change unit 237 that performs processing such as zero-filling (hereinafter, simply referred to as zero-fill or ZF) or cutting out on the measurement data to change the matrix size of the measurement data. In addition, in the preferred embodiment, the image processing unit 23 further comprises a filter unit 239 that applies a k-space filter to the k-space data prior to the final reconstruction.

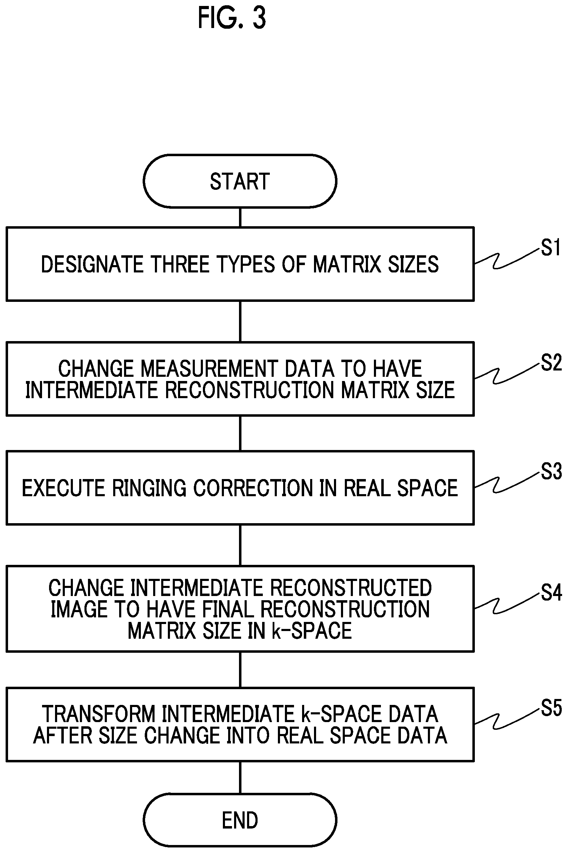

Fig. 3 shows an outline of the processing of the image processing unit 23 having the above-described configuration. It should be noted that, in the following description and the accompanying drawings, the measurement matrix (size) is denoted by "SM", the reconstruction matrix (size) is denoted by "RM", and the image is denoted by "I", and reference numerals for distinguishing each matrix and image are indicated by lower case letters such as "a, b, c, d, gt, in" following "SM", "RM", and "I".

In a case in which the measurement data (k-space data) is received from the imaging unit 10, the image processing unit 23 first sets three matrix sizes necessary for the processing of the image generation unit 231 (S 1) through the matrix size setting unit 232. One of the three matrix sizes is a measurement matrix size SMa of the received k-space data, which may be the matrix size of the measurement data itself or the matrix size of the k-space data after the measurement data is preprocessed and trimmed. Another is a second matrix size in which a ratio to the first matrix size is the same as the matrix ratio of the data set used for training the CNN 235, and is an intermediate reconstruction matrix size RMb. The third is a reconstruction matrix size RMd desired by a user, which is a size set by the user via the input device or a size set by default in an examination flow and changeable by the user. Specific examples of these settings will be described in detail in the following embodiments.

Next, the first reconstruction unit 231-1 reconstructs the measurement data having the first matrix size at the intermediate reconstruction matrix size RMb (S2). An intermediate reconstructed image Ib having the intermediate reconstruction matrix size is obtained by the reconstruction. Next, the intermediate reconstructed image Ib to correct the ringing that has occurred in the intermediate reconstructed image Ib by applying the CNN 235 (S3). Since the CNN 235 has been trained to output by using an image data set in which a ratio between the matrix size of the measurement data and the reconstruction matrix size is the same as a ratio between SMa and RMb, to output an image in which the ringing of the image reconstructed at the matrix ratio is corrected as a correct answer image, an intermediate reconstructed image Ic in which the ringing is corrected can be obtained by applying the CNN 235.

The intermediate reconstructed image Ic is transformed into the k-space data and is changed to a final reconstruction matrix size RMd in the k-space (S4). Finally, the k-space data is transformed into real space data to obtain a final reconstructed image (S5). The intermediate reconstructed image is subjected to the ringing correction, and the high-frequency components that cause ringing are removed in the k-space data obtained by transforming the intermediate reconstructed image. The change in the matrix size of the k-space data differs depending on whether the intermediate reconstruction matrix size is larger than or smaller than the final reconstruction matrix size. The zero-fill is performed in a case of a small size or cutting out the k-space is performed in a case of a large size, the size changing is performed, an appropriate k-space filter is applied depending on the matrix size. As a result, the ringing that has occurred during the second reconstruction is corrected.

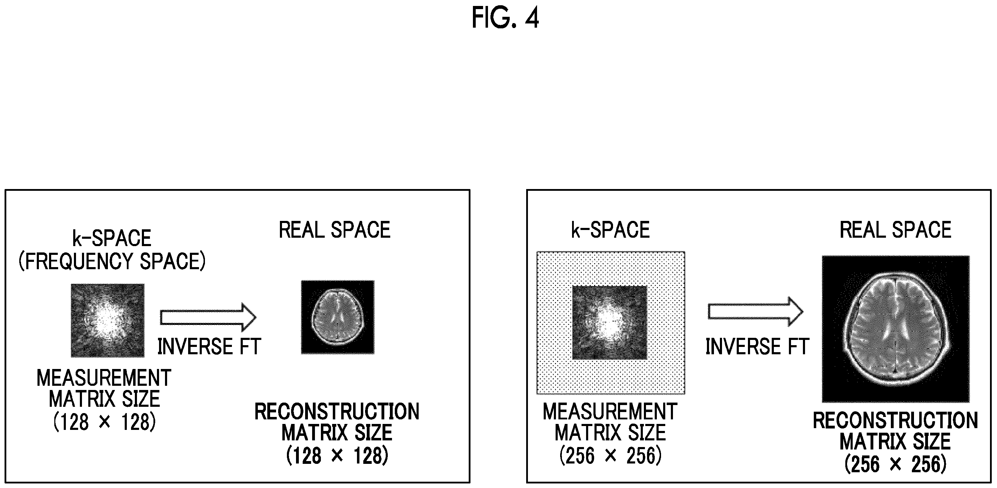

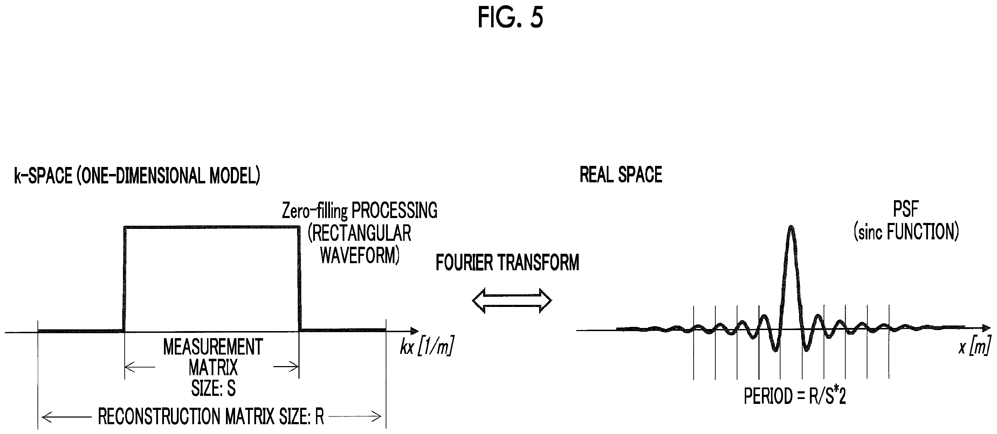

Since the final reconstructed image is created by using the k-space data from which the component causing the ringing has been removed by the ringing correction, the final reconstructed image is an image in which the ringing is significantly suppressed. In order to clarify the effect of the present invention, first, the occurrence of the ringing will be described with reference to Figs. 4 and 5.

The left side of Fig. 4 shows a case in which the measurement matrix size and the reconstruction matrix size are the same (both are 128 × 128 in this example), but as shown on the right side of Fig. 4, in a case in which 128 × 128 measurement data is zero-filled to 256 × 256 and then reconstructed, the matrix size of the reconstructed image is 256 × 256, and the apparent resolution is improved. However, as shown in Fig. 5, a point spread function (PSF) obtained by performing a Fourier transform on a cutout waveform of the k-space in a case of being zero-filled is a waveform represented by a sinc function with respect to a rectangular wave (cutout waveform of the k-space data).

As can be seen from the waveform, the point spread function PSF vibrates with a period of (RM/SM) * 2 in a case in which the measurement matrix size is SM and the reconstruction matrix size is RM. The frequency component of the vibration appears as a streak artifact (ringing) in the reconstructed image. That is, the period of the streak artifact (ringing) is determined by the ratio of the measurement matrix size to the reconstruction matrix size, that is, the matrix ratio. In the present embodiment, the characteristics in that the period of the ringing depends on the matrix ratio is utilized, and the CNN is trained by using an image set group with a fixed matrix ratio, the ringing correction using the CNN is performed, and then the transformation to the final reconstruction matrix is performed. As a result, the CNN can be easily constructed using a relatively small number of training data sets, and a ringing correction effect can be reliably obtained with any combination of the measurement matrix and the reconstruction matrix.

According to the present embodiment, by adopting a configuration in which only the matrix ratio is fixed and the CNN is trained and applied, the CNN can be applied to any spatial resolution and matrix size used in the examination, and a ringing correction effect can be obtained uniformly without depending on the imaging part or the contrast.

Hereinafter, embodiments of a specific configuration of the CNN and the processing of the image processing unit using the CNN will be described. In the following embodiments, the same reference numerals in the drawings referred to in the description of the configurations of the apparatus and computer described above are used as they are.

### Embodiment 1

In the present embodiment, a case will be described in which a final image having a desired matrix size larger than the matrix size of the measurement matrix is reconstructed by using the measurement data captured in any measurement matrix.

First, a specific configuration and a training step of the CNN 235 used for the ringing correction will be described.

In general, the CNN has a structure in which a plurality of convolution layers and pooling layers are stacked between an input layer and an output layer, and coefficients or weights of the layers are changed through training, so that a desired output is obtained. In the present embodiment, such a general CNN can also be adopted, but a complex-valued CNN is adopted because a complex image can be obtained in the MRI. By using the CNN corresponding to the complex image, the processing can be performed without being affected by an intensity or a phase of the signal.

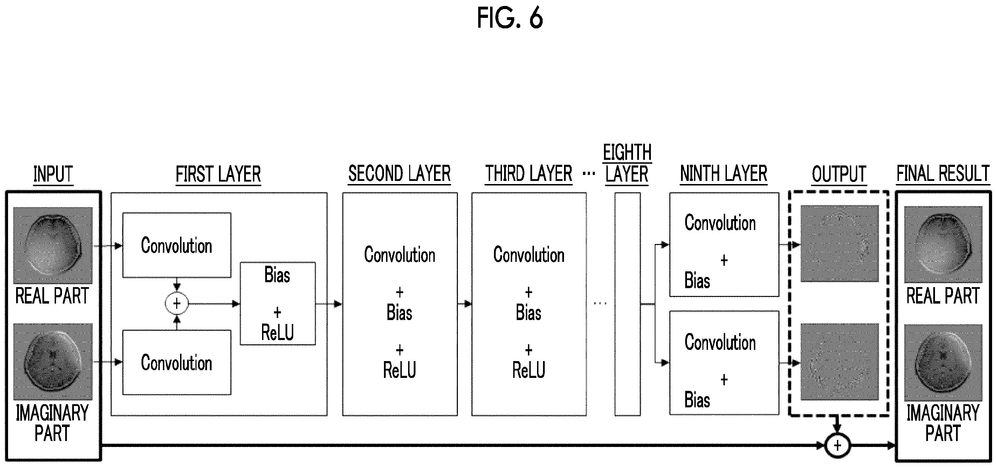

Fig. 6 shows an example of the complex-valued CNN adopted in the present embodiment.

The CNN 235 is a complex-valued CNN having a nine-layer structure in which each layer is formed by a block consisting of a convolution layer, an activation function (ReLU), and a pooling layer, the real part and the imaginary part of the input image are combined in the first layer, and the real part and the imaginary part are separated in the ninth layer. It should be noted that a kernel size or the number of channels of each layer is not particularly limited, but for example, the kernel size can be "3 × 3" to "9 × 9", and the number of channels can be "16 ch" to "128 ch".

It should be noted that, although a simple CNN is shown as an example in the present embodiment, the CNN is not limited to this. For example, a resolution-changed CNN, such as U-net, may be used.

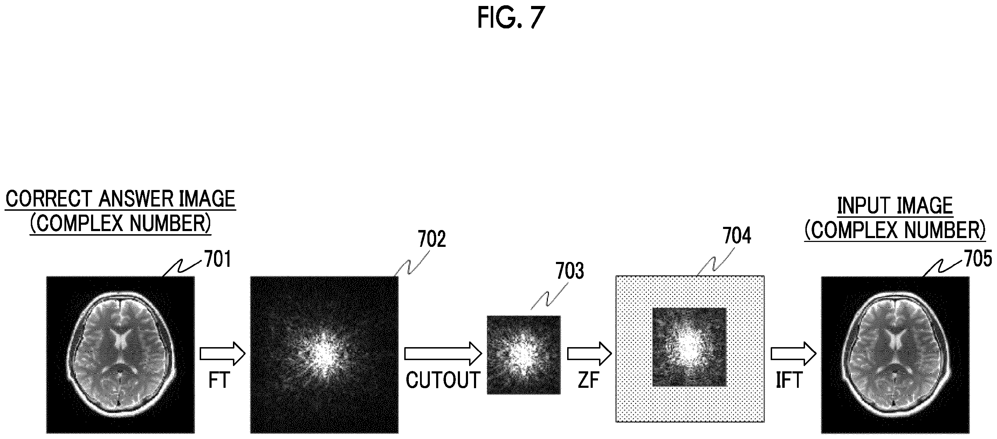

In the training step of the CNN, an image set including a plurality of correct answer images (complex number) and a plurality of input images (complex number) is prepared. The correct answer image (first image) is an image 701 in which the ringing has not occurred, as shown at the left end of Fig. 7. An input image (second image) 705 is generated by performing a Fourier transform (FT) on the correct answer image to obtain k-space data (first measurement data) 702, cutting out a low-frequency region of the k-space data at a predetermined size, performing zero-fill (ZF) of a high-frequency region on cutout data 703 to restore the data to its original size, and performing an inverse Fourier transform (IFT) on data (second measurement data) 704 after the matrix size change (right end of Fig. 7). That is, the input image is an image reconstructed at the reconstruction matrix size different from the measurement matrix size of the first measurement data. In this way, a combination of a large number of the correct answer images 701 and the input images 702 generated from the correct answer images 701 is used as the training image set.

Here, the matrix size of the correct answer image is not limited, and images of various matrix sizes can be used, but the ratio between the matrix size of the original measurement data (first measurement data) 702 and the matrix size of the cutout data (before the size change) 703 is fixed in any set. This ratio (fixed value) corresponds to a matrix ratio (reconstruction matrix size/measurement matrix size) in a case in which the cutout data is considered as the measurement data (first measurement data) of the second image (input image) and the reconstruction is performed at a reconstruction matrix size that is a predetermined matrix ratio to the measurement matrix size.

The CNN according to the present embodiment is created by using the training data with a constant matrix ratio, and for example, the following combinations can be made in a case in which the matrix ratio is 2.
Measurement matrix size: 256, Reconstruction matrix size: 512
Measurement matrix size: 384, Reconstruction matrix size: 768
Measurement matrix size: 300, Reconstruction matrix size: 600

It should be noted that, although only the size in the uniaxial direction is shown in this example, the matrix is not limited to a square and may also be an oblong, a circular shape or an elliptical shape inscribed in the rectangular shape, or 3D, and a plurality of matrix ratios may be used depending on the shape and the dimension of the matrix, but all of the matrix ratios are fixed values.

In this way, the CNN is trained such that the output image, in a case in which the CNN is applied to the input image, approaches the correct answer image by using the training image set in which the matrix ratio is fixed.

By using the CNN trained in this way, the ringing correction of the image reconstructed at the reconstruction matrix size that has a fixed matrix ratio to the measurement matrix size, is realized for measurement data of various sizes. That is, the measurement data with various different matrix sizes are changed in size at the same matrix ratio as the training image set, and then applied as the input image to the trained CNN 235, resulting in the output of a ringing-corrected image with a different resolution compared to the original image.

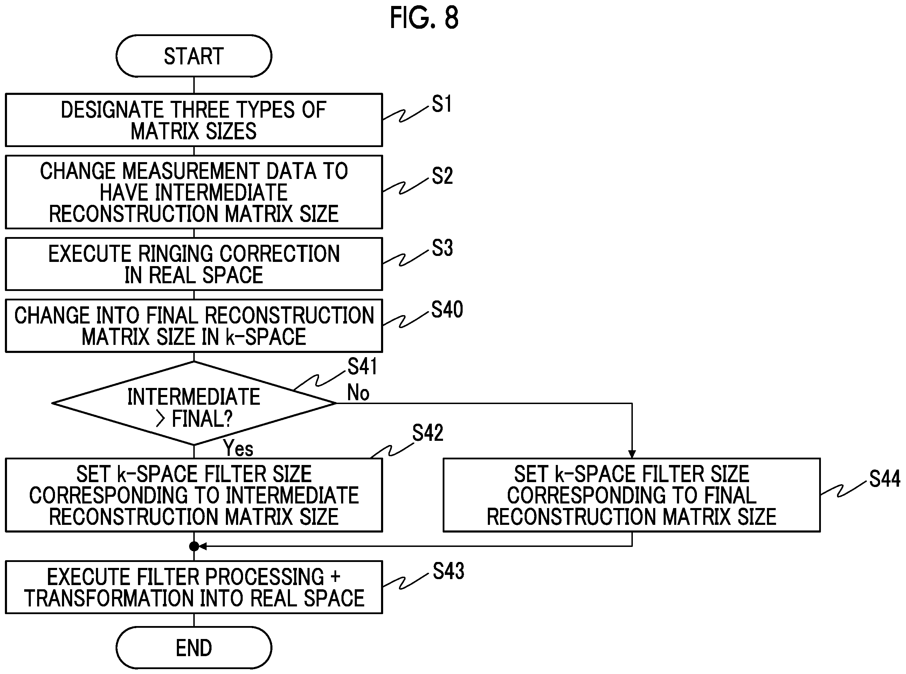

Next, the processing of the image processing unit 23 according to the present embodiment, including the ringing correction to which the CNN 235 is applied, will be described with reference to Figs. 8 and 9 to 11. In Fig. 8, the same processing as the processing in Fig. 3 is denoted by the same reference numerals, and the overlapping description is omitted.

### S1

In a case in which the image processing unit 23 receives the measurement data (measured k-space data) from the imaging unit 10, first, the matrix size setting unit 232 sets three matrix sizes necessary for the processing of the image generation unit 231, that is, the matrix size (measurement matrix size) SMa of the measurement data, the intermediate reconstruction matrix size RMb, and the final reconstruction matrix size RMd (S1). The ratio (matrix ratio) RMb/SMa (= N) of the measurement matrix size SMa to the intermediate reconstruction matrix size RMb is the same as the matrix ratio of the data (image set) used for training the CNN 235. In the present example, the final reconstruction matrix size RMd is larger than the measurement matrix size SMa (RMd > SMa), and the intermediate reconstruction matrix size RMb is larger than the measurement matrix size SMa.

### S2

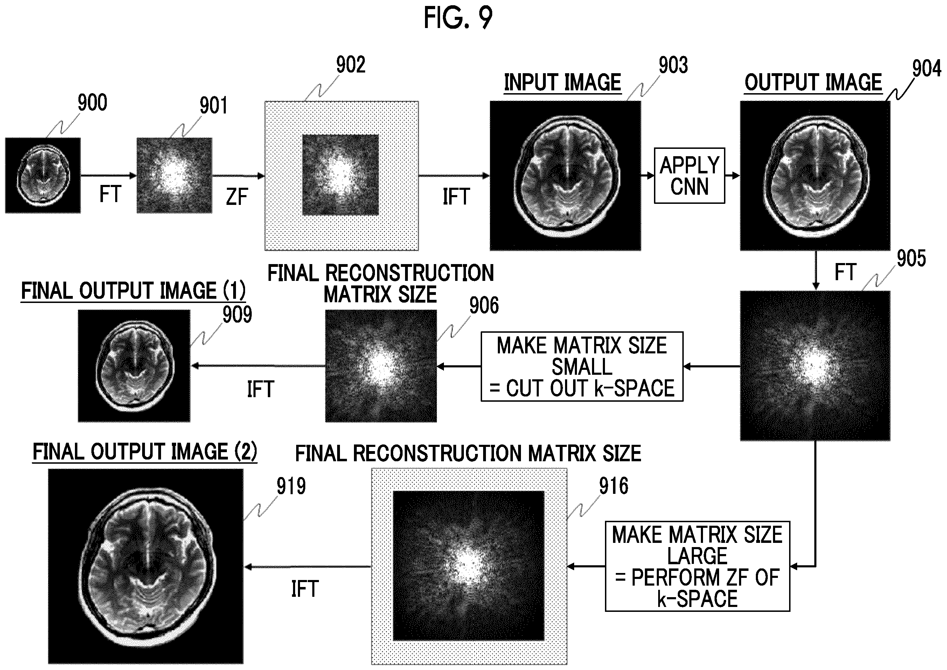

The matrix size change unit 237 changes the measurement data to the intermediate reconstruction matrix size RMb. Here, RMb > RMa, and the size change is expanded by performing zero-fill (ZF) of the high-frequency region on measurement data 901 of any measurement matrix, as shown in Fig. 9. It should be noted that, in a case in which the image data 900 has already been obtained, the image data 900 may be subjected to a Fourier transform (FT) and then used as measurement data 901.

### S3

The image generation unit 231 (first reconstruction unit 231-1) performs an inverse Fourier transform (IFT) on the measurement data 902 after the matrix size change to generate real space data 903 and performs the ringing correction using the CNN 235. That is, the real space data 903 is used as the input image for the CNN 235, and the CNN 235 is applied. As a result of this processing, a ringing-corrected image is obtained as an output image 904 of the CNN 235.

### S40 to S44

The output image 904 of the CNN 235 is an image with higher resolution than the original image data 900 because the surrounding region in the k-space is extrapolated, does not have the resolution desired by the user. Therefore, the matrix size change unit 237 adjusts the ringing-corrected image to match the final reconstruction matrix size RMd on the k-space data, and then performs the reconstruction. That is, the output image 904 is subjected to a Fourier transform (FT) to obtain k-space data 905, and the matrix size is changed to perform the final reconstruction (second reconstruction).

Here, processing is performed to prevent newly occurring ringing by changing the matrix size. The processing differs depending on whether the intermediate reconstruction matrix size RMb is larger than or smaller than the final reconstruction matrix size RMd.

### S42

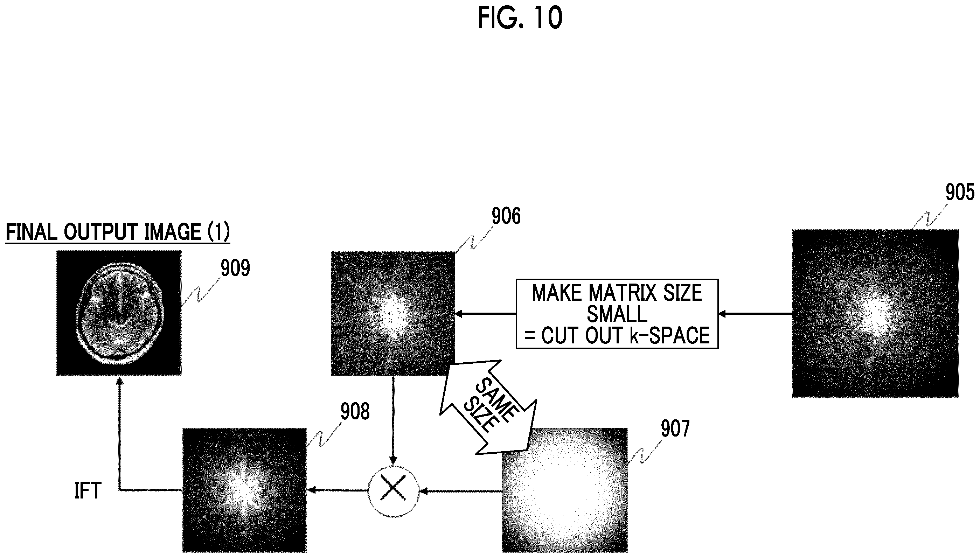

In a case in which RMb > RMd, as shown in Fig. 10, the processing of cutting out the k-space data 906 of the final reconstruction matrix size from the k-space data 905 having the intermediate reconstruction matrix size, and then a k-space filter (frequency filter) 907 having the same size as the final reconstruction matrix size RMd is set and applied.

As an example, in a case in which the measurement matrix size SMa is 192, the intermediate reconstruction matrix size RMb is 384, and the final reconstruction matrix size RMd is 256, by cutting out the matrix of 256 from the matrix of 384, the signal is truncated at an end portion of the reconstruction matrix, a step is generated, and the ringing occurs, even though the data (signal) at the matrix edge is extrapolated by applying the CNN 235. The step can be smoothed by using a k-space filter having the same size as the cutout k-space data 906, that is, the same size as the final reconstruction matrix size RMd, thereby preventing the newly occurring ringing due to the change in the matrix size.

It should be noted that, as the k-space filter 907, a generally available frequency filter, for example, a Gaussian filter, a Fermi filter, a Hanning filter, a Hanning filter only for an end portion, or a known truncation filter can be used.

### S43

Then, the image generation unit 231 (second reconstruction unit 231-2) performs an inverse Fourier transform (IFT) on the k-space data 908 after the filter is applied, to generate a final reconstructed image 909.

### S44

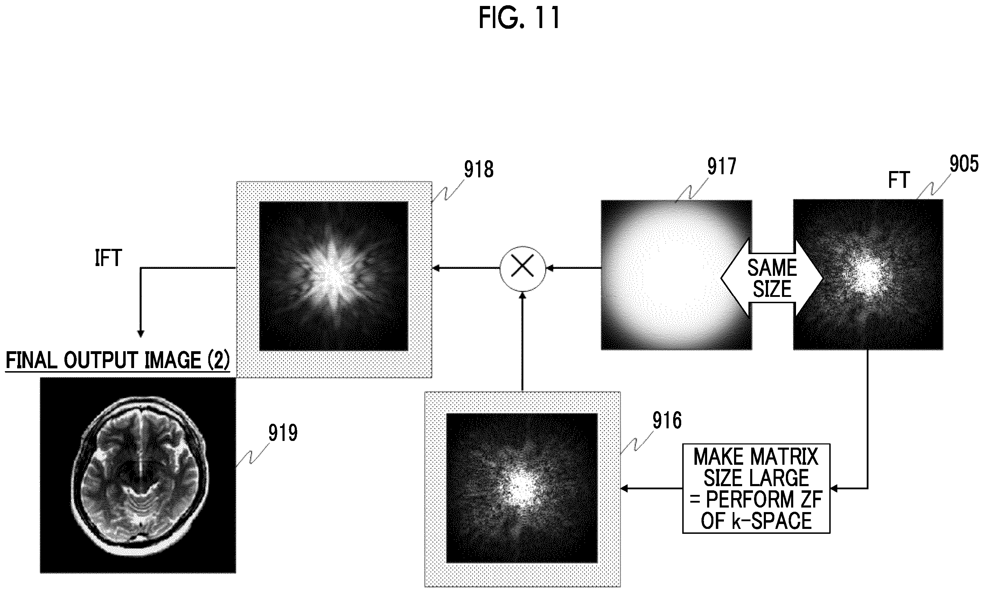

In a case in which RMb ≤ RMd, as shown in Fig. 11, first, the k-space data 905 of the intermediate reconstruction matrix size is subjected to zero-fill (ZF) and the size is expanded to the final reconstruction matrix size, and then a k-space filter 917 is applied to the expanded k-space data 916.

For example, in a case in which the measurement matrix size SMa is 192, the intermediate reconstruction matrix size RMb is 384, and the final reconstruction matrix size RMd is 512, the periphery of the matrix of 384 is subjected to zero-fill to be expanded to the matrix of 512.

This expansion creates a step between the end portion of the intermediate reconstruction matrix and the zero-filled periphery, which also causes the ringing. In order to eliminate the step, smoothing is performed by using a k-space filter having the same size as the matrix size of the k-space data 905 before the expansion, that is, the intermediate reconstruction matrix size RMb. As a result, it is possible to prevent newly occurring ringing due to the matrix size change.

### S43

Then, the image generation unit 231 (second reconstruction unit 231-2) performs an inverse Fourier transform (IFT) on the k-space data 918 after the filtering, to generate a final reconstructed image 919, in the same manner as in a case in which RMb > RMd.

As described above, according to the present embodiment, first, the measurement data obtained at the predetermined matrix size by the imaging unit is reconstructed after the size change at a constant matrix ratio (intermediate reconstruction), and then the ringing correction is performed on the intermediate reconstructed image by using the CNN that has been trained by using the image data set at the constant matrix ratio. Then, the resolution adjustment, including the size change and the filtering, is performed in the real space to obtain the final image having the final reconstruction matrix size.

As a result, it is possible to significantly suppress the occurrence of the blurring compared to a case in which the k-space filter is applied directly to the measurement data.

In addition, since it is not necessary to train the CNN by using, as the training data, various combinations of the measurement matrix size and the reconstruction matrix size, as in the ringing correction using the CNN in the related art, the CNN can be easily constructed and a high ringing suppression effect can be obtained.

### Embodiment 2

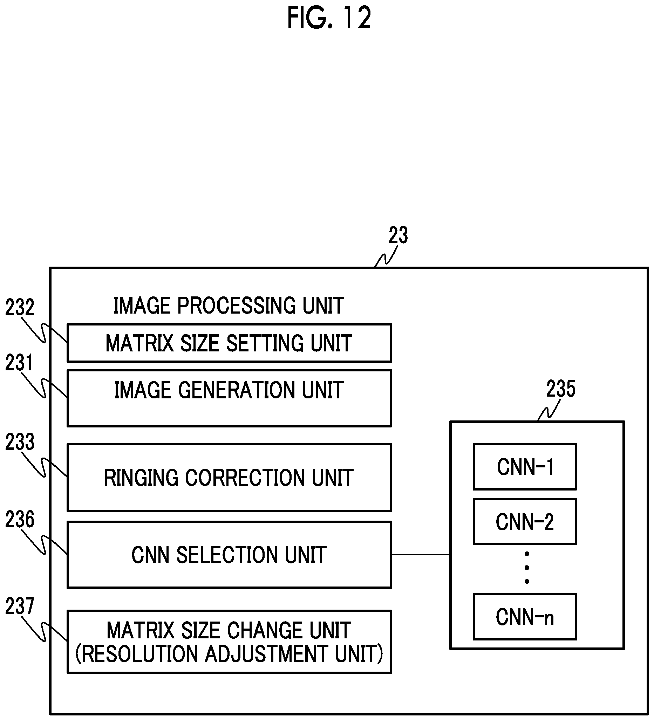

A case has been described in Embodiment 1 in which one CNN 235 that has been trained by fixing the matrix ratio between the reconstruction matrix and the measurement matrix is used, but as shown in Fig. 12, two or more CNNs 235 may be prepared for different matrix ratios, and any one of the CNNs 235 may be selected to perform the ringing correction. Therefore, the image generation unit 231 according to the present embodiment comprises a CNN selection unit 236.

As a criterion for selecting the CNN, for example, the CNN selection unit 236 selects the CNN 235 having a matrix ratio closest to a ratio between the final reconstruction matrix and the measurement matrix. As a result, a difference between the intermediate reconstruction matrix size and the final reconstruction matrix size can be minimized, and as shown in Fig. 5, the frequency of the vibration of the point spread function, which causes the ringing, can be shifted to the high-frequency side to the extent that the ringing is not noticeable, thereby suppressing the occurrence of the ringing during the final reconstruction.

In the present embodiment, it is necessary to construct a plurality of CNNs 235, but all of the CNNs 235 can adopt various images without restrictions regarding the matrix size, the contrast, the imaging part, and the like of the training image data set, and can be constructed using the same original image, thereby simplifying the training step compared to the ringing correction CNN in the related art.

Although the embodiments of the MRI apparatus and the image processing method realized by the MRI apparatus according to the embodiment of the present invention are described above, a part of the functions of the image processing unit of the MRI apparatus, particularly each processing of the image processing method according to the embodiment of the present invention, can also be implemented in a computer different from the MRI apparatus, and an image processing apparatus having such a configuration is also included in the present invention.

### Explanation of References

1: MRI apparatus
10: imaging unit
20: computer
23: image processing unit
231: image generation unit
232: matrix size setting unit
233: ringing correction unit
235: CNN
237: matrix size change unit
23 9: filter unit

## Claims

1. A magnetic resonance imaging (1) apparatus comprising:
an imaging unit (10) that collects measurement data consisting of magnetic resonance signals; and
one or more processors that reconstruct the measurement data at a desired reconstruction matrix size, and perform ringing correction on a reconstructed image,
wherein the one or more processors are configured to
set a measurement matrix size of the measurement data, an intermediate reconstruction matrix size having a predetermined matrix ratio to the measurement matrix size, and the desired reconstruction matrix size,
reconstruct the measurement data at the intermediate reconstruction matrix size to generate an intermediate reconstructed image, and
reconstruct k-space data of a corrected intermediate reconstructed image obtained by performing ringing correction on the intermediate reconstructed image via the ringing correction unit, at the desired reconstruction matrix size.

2. The magnetic resonance imaging (1) apparatus according to claim 1,
wherein the one or more processors include a CNN that has been trained by using a plurality of image sets consisting of a first image in which ringing has not occurred and a second image in which ringing has occurred, and the second image is an image obtained by changing a size of the first image and reconstructing the first image in a k-space at the predetermined matrix ratio.

3. The magnetic resonance imaging (1) apparatus according to claim 2,
wherein the second image used for training the CNN is an image obtained by performing an inverse Fourier transform on the first image to obtain first k-space data, cutting out a low-frequency region from the first k-space data to obtain data, performing zero-filling of a high-frequency region on the data to obtain second k-space data having the same matrix size as the first k-space data, and performing an inverse Fourier transform on the second k-space data.

4. The magnetic resonance imaging (1) apparatus according to claim 2 or 3,
wherein the CNN is a complex-valued CNN.

5. The magnetic resonance imaging (1) apparatus according to any one of claims 2 to 4,
wherein the one or more processors are further configured to change a size of the intermediate reconstructed image after the CNN is applied, in a measurement space.

6. The magnetic resonance imaging (1) apparatus according to claim 5,
wherein the one or more processors are further configured to transform the intermediate reconstructed image after the CNN is applied into k-space data, and then perform at least one of cutout processing or zero-filling processing on the k-space data to change a size of the k-space data.

7. The magnetic resonance imaging (1) apparatus according to claim 5 or 6,
wherein the one or more processors are further configured to apply a frequency filter after change of the size.

8. The magnetic resonance imaging (1) apparatus according to claim 6 and 7,
wherein the intermediate reconstruction matrix size set by the one or more processors is larger than the desired reconstruction matrix size, and
a size of the frequency filter applied by the filter unit is the same as a size of the k-space data after the size change.

9. The magnetic resonance imaging (1) apparatus according to claim 6 and 7,
wherein the intermediate reconstruction matrix size set by the one or more processors is equal to or smaller than the desired reconstruction matrix size, and
a size of the frequency filter applied by the filter unit is the same as a size of the k-space data before the size change.

10. The magnetic resonance imaging (1) apparatus according to any one of claims 2 to 9,
wherein the one or more processors include a plurality of the CNNs in which the predetermined matrix ratios used for training are different.

11. The magnetic resonance imaging (1) apparatus according to claim 10,
wherein the one or more processors select, from among the plurality of CNNs, a CNN having a predetermined matrix ratio closest to a ratio between the desired reconstruction matrix size and the measurement matrix size, and set the intermediate reconstruction matrix size by using the matrix ratio of the selected CNN.

12. The magnetic resonance imaging (1) apparatus according to any one of the preceding claims,
wherein the desired reconstruction matrix size set by the one or more processors is larger than the measurement matrix size, and the predetermined matrix ratio (intermediate reconstruction matrix size/measurement matrix size) is larger than 1.

13. An image processing method of reconstructing a ringing-corrected image by using measurement data consisting of magnetic resonance signals collected by a magnetic resonance imaging (1) apparatus, the image processing method comprising:
a first reconstruction step of reconstructing the measurement data at a reconstruction matrix size having a predetermined matrix ratio to a measurement matrix size to generate an intermediate reconstructed image;
a correction step of performing ringing correction on the intermediate reconstructed image by using a CNN that has been trained by using a set including a first image in which ringing has not occurred and a second image in which ringing has occurred and that outputs an image in which ringing is corrected with respect to an input image; and
a second reconstruction step of transforming the intermediate reconstructed image after the ringing correction into k-space data and reconstructing the k-space data at a desired reconstruction matrix size,
wherein the second image used for training the CNN is an image which is obtained by changing a size of the first image and reconstructing the first image in a k-space at a reconstruction matrix size of the first image and in which the reconstruction matrix size and a matrix size after the size change satisfy the predetermined matrix ratio.

14. The image processing method according to claim 13,
wherein the second reconstruction step includes a step of transforming the intermediate reconstructed image into the k-space data, changing a size of the k-space data in the k-space, and applying a frequency filter.
